# EUROPEAN PATENT APPLICATION

(11) **EP 4 826 399 A1**
(43) Date of publication of application: **21.10.2026**
(21) Application number: 25171321.0
(22) Date of filing: 17.04.2025
(51) Int. Cl.: G01R 31/3167

(54) **METHODOLOGY FOR DEFECT ANALYSIS AND DETECTION IN MIXED-SIGNAL IC ACCELERATORS OF NEURAL NETWORKS**

(71) Applicant: Innatera Nanosystems B.V., 2288 GK Rijswijk (NL)
(72) Inventor: LEPRI, Nicola, The Hague (NL); MOUTINHO TEIXEIRA, Rui Andre, Delft (NL); DALAKOTI, Aditya, Voorschoten (NL); ZJAJO, Amir, The Hague (NL)
(74) Representative: Hoyng Rokh Monegier B.V.

(57) **Abstract**

The present invention relates to a method for generating a test set for defect detection in a mixed-signal IC neural network accelerator. The method comprises identifying a number of mixed-signal neuromorphic blocks present on the accelerator and simulating the response of the accelerator to generated input signals. One then extracts from the simulation for each mixed-signal neuromorphic block a defect and/or fault statistics. A taxonomy is created of neuromorphic faults based on the extracted defect and/or fault statistics. Finally, the test set is generated for the accelerator based on the created taxonomy of neuromorphic faults.

## Description

### TECHNICAL FIELD

This disclosure generally relates to techniques and procedures for the analysis and the detection of electrical defects in integrated circuits caused by manufacturing flaws, in particular for hardware mixed-signal integrated circuit accelerators of Neural Networks (NN) of any kind and topology.

### BACKGROUND

With the scaling of technology nodes towards nanometric feature sizes, integrated circuit (IC) testing has become increasingly complex and critical. While digital ICs benefit from standardized test procedures and methods, analog IC testing remains significantly more challenging due to its continuous signal nature and sensitivity to process variations. Unlike digital circuits, which can be tested using deterministic logic patterns, analog ICs require more precise measurements of different parameters, making defect detection more difficult.

Furthermore, the lack of standardized fault models, the high-test costs due to the long test times, and the need for specialized instrumentation increase the overall complexity. At the same time, ensuring reliability and ultra-low failure probability has become mandatory, as analog ICs are widely used in safety-critical applications like automotive, medical, and communication systems.

The case of mixed-signal IC hardware accelerators of neural networks is peculiar. Indeed, the inherent model robustness and the abundance of basic computing units like neurons, presynapses or synapses help deliver more reliable products, while on the other hand the adopted network topologies are usually difficult to scan for defects because of their volume and of lack of observable spots.

Leveraging ad hoc solutions for mixed-signal NN accelerators appears as a compulsory approach to make defect analysis and detection feasible in products that need to achieve high reliability and safety standards, as well as a way to decrease the testing costs also for accelerators used in non-critical applications. Such an industry-compatible methodology is not publicly known today for this purpose and field.

It is therefore an object of the present invention to solve one or more of the abovementioned problems.

### SUMMARY

To address one or more of the above discussed drawbacks of the prior art, the present invention provides a method accelerator according to the appended claims.

The present invention discloses a comprehensive methodology for defect analysis and detection in mixed-signal IC accelerators of Neural Networks. Compliant with the consolidated IEEE P2427 standard draft by IEEE, this methodology is the first production testing framework in the field and leverages solutions and techniques that are novel for this application field. These innovations benefit from and address the peculiar nature of neuromorphic computing primitives and the mixed-signal ultra-low power circuit blocks that embody them.

A mixed-signal IC neural network accelerator is an integrated circuit designed to perform neural network computations using a combination of analog and digital signal processing, leveraging the high energy efficiency and parallelism of analog computation alongside the precision and programmability of digital logic. Such accelerators typically implement key neural network operations-such as multiply-accumulate (MAC) and activation functions-using analog circuits (e.g., capacitive charge sharing, current summing, or resistive crossbar arrays), while managing data flow, control logic, and configuration digitally. This hybrid architecture enables low-latency, high-throughput inference with reduced power consumption and silicon area compared to purely digital designs.

A mixed-signal neuromorphic block (MNB) is a mixed-signal circuit block, i.e. potentially including both analog and digital circuitry, that performs a neuromorphic computational primitive. As examples, commonly adopted MNB units in NN accelerators are the presynapse, synapse, and the neuron.

A presynapse in a neural network may refer to the output end of a preceding computational element-typically a neuron-that transmits a signal to a downstream neuron via a connecting synapse. The presynapse may hold the activation value resulting from a prior computation and may be responsible for initiating signal propagation in the network. In hardware implementations, a presynapse may be embodied as a charge on a capacitor, a voltage level on a wire, or a digital register value held within a memory element.

A synapse constitutes the weighted connection between two neurons, facilitating signal transmission from a presynapse to a postsynaptic target. In artificial neural networks, each synapse is associated with a numerical weight that modulates the strength and direction of the transmitted signal. The synapse performs a multiplication operation between the presynaptic activation and the synaptic weight, producing a contribution to the target neuron's input. In mixed-signal IC implementations, synapses can be realized using programmable analog elements such as digital-to-analog converters (DACs), floating-gate transistors, or resistive memory elements (e.g., memristors), enabling low-power and area-efficient multiply-accumulate (MAC) operations directly in the analog domain.

A neuron is a computational unit that aggregates multiple weighted inputs, optionally applies a bias, and may process the result through a nonlinear activation function to produce an output signal. The neuron may collect the outputs of several synapses, typically summing them to compute a total input or membrane potential, which may then be transformed by a nonlinear function. In a mixed-signal IC accelerator, the neuron can be implemented using analog summing circuits followed by analog or mixed-signal non-linear activation circuits. Alternatively, analog summation can be followed by digitization via an analog-to-digital converter (ADC), with the non-linear function applied in the digital domain.

A physical defect is an unexpected local physical anomaly during the accelerator manufacturing that may or may not affect the MNB operation, e.g. a dust particle, flake, resist residue, irregularities in the etching or photolithography pattern, etc. The possible impact in the MNB operation can be approximated via a topological or parametric change in its circuit.

An electrical defect is a topological or parametric change in the nominal circuit to account for a physical defect. The topological change is typically represented by the insertion of a resistor or other components.

A neuromorphic fault is a change in the functionality of the MNB due to the presence of an electrical defect. An electrical defect may be causing a neuromorphic fault in a certain scenario and not causing it in another scenario, e.g. with different input. Neuromorphic faults can be categorized into neuromorphic behavioral fault and neuromorphic parametric fault.

A neuromorphic behavioral fault is a significant change in the behavior of the MNB due to the presence of an electrical defect.

A neuromorphic parametric fault is a moderate change in one or few specs of the MNB due to the presence of an electrical defect.

A tolerance window is a pre-defined acceptable output range for a specific test running on a specific MNB.

Chip binning is a process of sorting the manufactured IC accelerators based on their tested performance. This ensures that every product is allocated to the appropriate application or customer requirement, optimizing yield and usability.

The present invention consists in a comprehensive methodology for defect analysis and detection via testing in the context of mixed-signal hardware IC accelerators of Neural Networks.

### BRIEF DESCRIPTION OF DRAWINGS

Embodiments will now be described, by way of example only, with reference to the accompanying schematic drawings in which corresponding reference symbols indicate corresponding parts, and in which:
FIG. 1 schematically shows a method according to the general methodology according to the invention;
FIG. 2 schematically shows a method to obtain defect and fault statistics according to the invention;
FIG. 3 schematically shows a method to compute weighted defect coverage during test set optimization via simulation according to the invention;
FIG. 4 schematically shows a method for obtaining a tolerance window definition according to the invention.

### DESCRIPTION OF EMBODIMENTS

Hereinafter, certain embodiments will be described in further detail. It should be appreciated, however, that these embodiments may not be construed as limiting the scope of protection for the present disclosure.

The present invention will be described with respect to particular embodiments and with reference to certain drawings, but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may refer to the same embodiment.

Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim.

Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some, but not other features included in other embodiments, combinations of features of different embodiments are meant to be within the scope of the invention, and form different embodiments, as would be understood by those in the art. For example, in the following claims, any of the claimed embodiments can be used in any combination. In the description provided herein, numerous specific details are set forth. However, it is understood that embodiments of the invention may be practiced without these specific details. In other instances, well-known methods, structures and techniques have not been shown in detail in order not to obscure an understanding of this description.

A mixed-signal integrated circuit accelerator of a neural network is a specialized hardware component that combines both analog and digital circuitry to efficiently perform neural network computations, such as matrix multiplications and activation functions. By leveraging analog processing for high-speed, low-power operations-particularly in tasks like multiply-accumulate (MAC)-and digital logic for control, data routing, and precision tasks, these accelerators achieve significant gains in energy efficiency and throughput compared to purely digital counterparts.

A Neural network accelerator may process signals from a broad range of sensor modalities by receiving input data-either in analog or digital form-and performing optimized computations tailored to each signal type. The signal types may include e.g. vision, audio, motion and inertial, environmental, biometric/biomedical/chemical, radar and lidar, and tactile and pressure sensors.

For vision and audio sensors, accelerators typically extract spatial or temporal features directly from pixel or waveform data. Motion and inertial sensors, such as accelerometers and gyroscopes, may generate time-series data that are analysed for patterns indicating movement, orientation, or gestures. Environmental sensors may measure parameters like temperature, humidity. Biometric, biomedical, and chemical sensors, including ECG, PPG, or biosensors, are often interfaced with preprocessing circuits for noise reduction and then analyzed using models trained for signal segmentation or condition monitoring. Radar and LiDAR sensors produce high-dimensional spatial data, which are processed using neural networks for object detection, range estimation, or scene reconstruction. Tactile and pressure sensors provide spatial pressure distributions or time-series patterns, enabling e.g. touch recognition. Across all modalities, the accelerator performs key tasks such as feature extraction, classification, and inference, enabling real-time, low-power sensor data interpretation.

In a mixed-signal integrated circuit accelerator implementing a spiking neural network (SNN) using analog components, sensor signals are processed through event-driven neural computations that mimic biological neural dynamics. Analog front-end circuits may interface directly with the sensors (or via a DAC) to capture continuous signals-such as light intensity, sound pressure, or bioelectrical activity-and convert them into discrete spikes based on thresholding, encoding schemes, or temporal changes. These spikes are then propagated through a network of analog neurons and synapses, where signal processing operations such as integration, leakage, and synaptic weighting are performed using current-mode or charge-based analog circuits. The mixed-signal architecture leverages analog efficiency in computation while using digital control logic for network configuration, spike routing, and/or timing management. This allows for ultra-low-power, low-latency processing of diverse sensory inputs, making the architecture particularly well-suited for real-time edge applications with power constraints and sparse, asynchronous data.

In a spiking neural network implemented using analog components, each circuit element may be designed to physically represent a functional unit of the neural network architecture. Individual analog circuits may be configured to act as synapses, where adjustable elements such as floating-gate transistors, memristors, or programmable capacitors encode the synaptic weight and modulate the strength of incoming spikes. Neuron circuits may comprise of integrator and thresholding elements, often implemented with operational amplifiers, capacitors, and transistors, to accumulate input charge, model membrane potential dynamics, and generate output spikes when a firing threshold is reached. Axonal delays, refractory periods, and leaky integration behaviours can also be embodied in passive or active analog subcircuits.

In general, the neural network accelerator may be configured to implement a variety of neural network architectures, including but not limited to feedforward neural networks (FNNs), convolutional neural networks (CNNs), recurrent neural networks (RNNs), long short-term memory (LSTM) networks, gated recurrent unit (GRU) networks, autoencoders, and spiking neural networks (SNNs). These architectures may be selected based on the nature of the sensor data and the intended application, such as spatial processing of image data using CNNs, temporal analysis of time-series data using RNNs, or low-power event-driven inference using SNNs. Other examples of neural networks include perceptron, feed forward neural networks, radial basis network, deep feed forward, auto encoder, variational AE, denoising AE, sparse AE, Markov chain, Hopfield network, Boltzmann machine, restricted BM, deep belief network, deep convolutional network, deconvolutional network, deep convolutional inverse graphics network, generative adversarial network, liquid state machine, extreme learning machine, echo state network, deep residual network, Kohonen network, support vector machine, or neural Turing machine. The accelerator may include configurable analog and digital circuit blocks that correspond to network layers, neurons, and synapses, allowing for implementation and inference of different types of neural models within the same hardware platform.

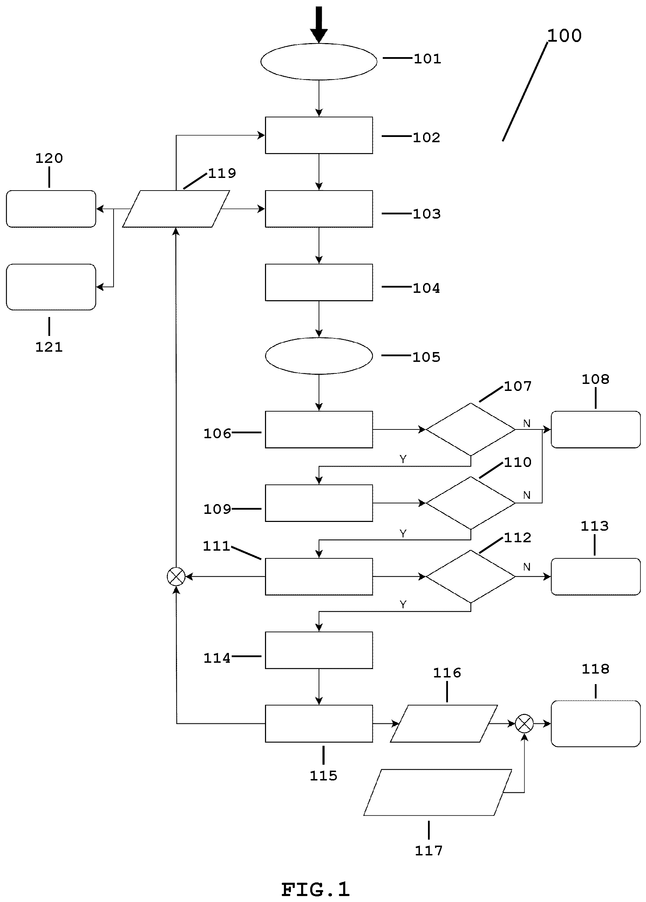

FIG. 1 schematically shows a method 100 according to the general methodology according to the invention. The embodiment discloses a general methodology for defect analysis and detection in mixed-signal IC accelerators of Neural Networks.

The method 100 is composed of several steps, summarized here below.

The first step comprises a preparatory simulation campaign and later ongoing refinement steps.

At step 101 the simulation campaign is initiated. In this step, the envisioned neuromorphic accelerator is simulated, and the different mixed-signal neuromorphic block (MNB) that are present on the neuromorphic accelerator are identified.

At step 102, for each MNB, an extraction takes place of defect and fault statistics via simulation, i.e. an estimation is obtained of how much the various electrical defects that can be present in the MNB are probable, as well as how much the possibly corresponding neuromorphic faults are probable.

The simulation may be performed by a computing system comprising at least one processor configured to execute program instructions and a memory storing a set of instructions which, when executed by the processor, cause the computing system to: (1) model the analog and digital components of the accelerator, (2) simulate the interaction between the analog and digital models in response to the input signals, and (3) generate output data representing the simulated response of the accelerator. The computing system may furthermore comprise a data storage unit for storing input signal data, simulation parameters, and resulting simulation output data and optionally, an interface for displaying or exporting the simulation results.

At step 103, for each MNB, a reasonably sized taxonomy of the neuromorphic faults is created, based on the defect and fault statistics extracted in step 102. An assignment of a neuromorphic risk coefficient to each class can furthermore take place. The risk coefficient of a neuromorphic fault may be computed as an average impact of this kind of neuromorphic fault on the NN inference. For each MNB, a taxonomy of neuromorphic faults is constructed. This taxonomy organizes the various types of faults observed or expected in the MNB into defined categories, using the defect and fault statistics obtained during the earlier analysis in step 102. The purpose of this classification is to provide a structured understanding of how faults manifest within neuromorphic hardware, taking into account their underlying causes and their potential impact on neural network behaviour. To quantify this impact, each fault class can be assigned a neuromorphic risk coefficient, which serves as a metric for the average severity of that fault class on NN inference accuracy or reliability. For instance, faults that consistently lead to significant inference degradation may receive higher risk coefficients than faults that have little to no functional impact. This risk-based approach allows for prioritization in later testing and mitigation strategies.

At step 104, a test set for defect detection is generated. The test set may aim for a high weighted defect coverage in a short time and with limited testing costs. A targeted test set is thus generated to detect defects in the neuromorphic hardware. The goal of the test set is to maximize the detection of high-risk or high-probability defects-especially those identified in the taxonomy created in step 103-while minimizing test time and associated costs. This is typically achieved by selecting tests that are most likely to provoke observable deviations in the circuit's behaviour when specific faults are present. The test set may be optimized to achieve high weighted defect coverage, meaning that the tests are chosen not only to cover many defects, but to do so in proportion to their associated risk or likelihood. This ensures that the most impactful defects are prioritized in the testing process, enabling effective quality control and resource-efficient test planning for neuromorphic hardware.

A test set for a mixed-signal IC accelerator for neural networks may be a collection of input stimuli and expected response criteria, designed to evaluate the functional correctness and performance of the accelerator under controlled conditions. The test set may be composed of: predefined digital or analog input data applied to the accelerator (e.g., encoded input feature maps, weights, control signals), specific operational modes or sequences (e.g., convolution, pooling, quantization) relevant to neural network inference, tolerance windows or thresholds which are acceptable deviation ranges for analog outputs or timing margins, accounting for noise, quantization, and process variations, reference outputs or golden results which are known-good output values computed by an ideal model or reference implementation.

The test set may be tailored to exercise key functional paths, critical timing paths, and analog front-ends (e.g., ADCs, DACs, neuron circuits), with the aim of detecting faults, measuring inference accuracy, and evaluating circuit stability under realistic NN workloads.

A test, within the context of such a test set, refers to an individual test case or stimulus-response evaluation. A test may involve applying a specific set of input signals to the IC accelerator (e.g., a test vector representing a particular NN input tensor), executing the corresponding operation on the IC (e.g., a layer of matrix multiplication or a convolution operation), measuring or capturing the output(s) of the IC (analog or digital) and comparing the output to a reference value or expected behaviour, possibly within predefined tolerance limits (especially relevant for analog components subject to variability).

A test may target a specific module (e.g., MAC array, synapse DACs, neuron circuits, mixed-signal neuromorphic block) or a system-level function (e.g., end-to-end inference on a test input), and may be designed for fault detection, parametric verification, or performance benchmarking (e.g., latency, power, accuracy).

While these steps 102-104 of the simulation campaign must be carried out at least once as preliminary steps before the testing campaign, further refinement can be obtained by iterative calibration of their outcomes based on results and data gathering from the experimental campaign. For example, one or more of the steps 102-104 can be repeated if the test set does not fulfil a required pre-determined weighted defect coverage in a particular pre-determined time and with particular pre-determined testing costs. For example, the taxonomy of the neuromorphic faults created in step 103 can be altered to take more, or less, fauls into account.

Note that while the defect and/or fault statistics are extracted from a simulation for each mixed-signal neuromorphic block, the defect and/or fault statistics can also at least partly be determined by empirical testing of mixed-signal neuromorphic blocks.

A second step comprises an experimental testing campaign.

At step 105 the experimental testing campaign is initiated.

At step 106, a first screening takes place of the accelerator based on built-in process monitors and a few simple metrics. At step 107 it is then examined whether the chip is usable. If it is found that the chip is not usable (N), at step 108 the chip is discarded. It is through this initial screening that a first part of faulty accelerators is discarded. The focus of the first screening is not on the different MNBs present on the accelerator but rather on fundamental blocks, e.g. the power supply circuitry or the I/O connectivity.

If it is found at step 107 that the chip is usable (Y), at step 109 a test set for detection of electrical defects in all the circuits apart from the MNBs is executed. This may thus be a test of the non-neuromorphic circuitry present on the chip. At step 110 it is then again examined whether the chip is usable. If it is found that the chip is not usable (N), at step 108 the chip is discarded.

If it is found at step 110 that the chip is usable (Y), at step 111 a limited test set for detection of electrical defects that make or could potentially make MNBs not calibratable may be executed, based on specifications dictated by the adopted calibration routine. At step 112, it is examined whether a particular MNB is calibratable. The non-calibratable MNBs (N) may be ruled out at step 113 and assigned a minimum score in the calibration routine. In case calibration is not expected, this step may be skipped.

If it is found at step 112 that the chip is usable (Y), at step 114 the calibration routine for the MNBs that have been assessed as calibratable is executed. In case calibration is not expected, this step is skipped.

At step 115, the test set for detection of post-calibration electrical defects in the MNBs is executed. Consequently, at step 116 the MNBs are graded according to the adopted neuromorphic scoring system.

At step 117, after test operations can be performed. For example, if needed or worthwhile, customized remapping and calibration can be performed based on the electrical defects present on the single accelerator. Furthermore, for example if needed or worthwhile, adaptation and retraining of the NN topology can be performed accordingly with the hardware constraints imposed by the presence of electrical defects.

At step 118, depending on the adopted neuromorphic scoring system and chip binning scheme, the accelerators can be classified and subsequently assigned to a corresponding performance class or use case.

A third step may comprise data collection of the various tests, and the input of this data as feedback into the simulation campaign.

At step 119, test data from steps 111 and/or 115 may be collected. Test data from step 106 and/or step 109 may also be used (not shown). This data may be used for refinement of for example steps 102 and/or 103, changing e.g. the estimation of how much the various electrical defects that can be present in the MNB are probable, and/or how much the possibly corresponding neuromorphic faults are probable. Furthermore, at steps 120 and 121 respectively analysis on defect density and impact for future refinement of the neural network design and training, and for future refinement of accelerator architecture and circuit design.

In order to carry out the proposed methodology, it is necessary to build the statistics of electrical defects and the possibly corresponding neuromorphic faults. Indeed, their probability distributions directly influence the test set generation and optimization, as well as represent a determining factor in possible network calibration or remapping schemes. Furthermore, at a later stage such information represents a fundamental basis for possible refinements and adaptation at network, algorithmic, and circuital level.

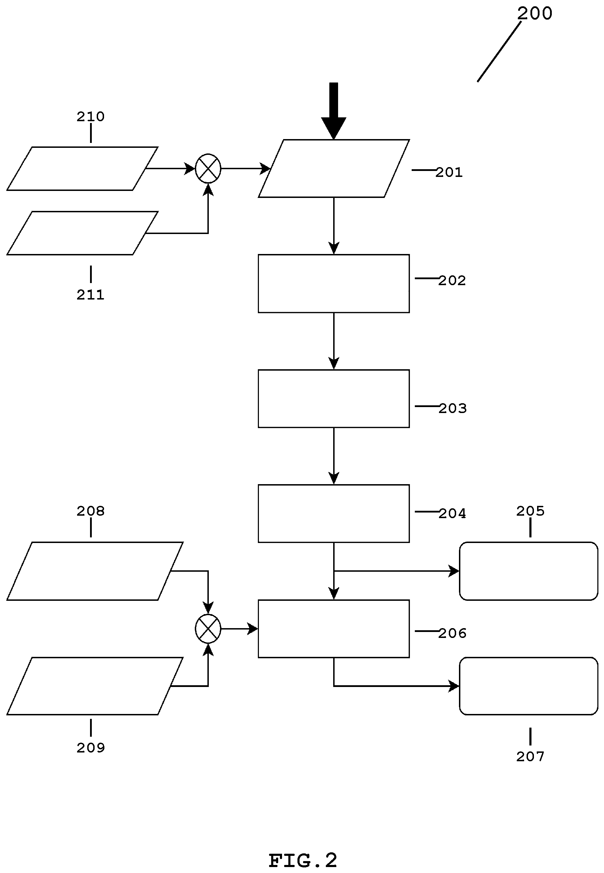

FIG. 2 schematically shows a method 200 to obtain defect and fault statistics according to the invention. The embodiment illustrates the factors influencing the statistics of electrical defects and the statistics of neuromorphic faults, sorted according to an ascending abstraction level order. FIG. 2 shows a flowchart illustrating the extraction of the statistics of electrical defects and neuromorphic faults.

It is convenient to depict the whole multivariate probability distribution from the manufacturing process to the high-level neuromorphic behavior of the MNBs, corresponding to the neuromorphic fault probability distribution. The electrical defect probability distribution will come as an intermediate result.

The steps of the method 200 that are used for determining the probability distribution are now discussed. These steps can be in conformity with the IEEE P2427 standard.

At step 201, statistical information on the manufacturing process defects, such as the defect density or the defect size probability distribution are obtained. This information might not be directly accessible, however the information can be derived from empirical models 210 and /or experimental validation tests 211 in order to tune the model parameters.

At step 202, the physical design and layout of the MNBs and/or of the accelerator may be determined. Physical characteristics of the circuitry (such as for example the distance between metal lines, the metal line width and length, and the area of vias between different metal layers) determine the probability of a certain physical defect to occur in a certain location. Furthermore, the physical characteristics of the circuitry may influence the possibility for a physical defect to cause an electrical defect.

At step 203, the physical defects may be mapped to electrical defects. The specific function that maps the physical defects to the electrical defects may be chosen in a way that ensures a model both manageable and sufficiently accurate. Functions could be selected that for certain physical defects insert a resistor in the model to simulate the resistance values of the physical defect. One can implement one or more resistive values per defect type and/or one can use more complex models, e.g. a 3-resistor network to represent an open defect at transistor gates.

At step 204, the transistor-level design of the MNBs is determined. Circuit design choices may result in different physical defects collapsing onto the same electrical defect or they may introduce functional redundancy, making an electrical defect virtually impossible to detect and/or not detrimental in any relevant scenario. Device sizing may influence the probability distribution, since bigger components might have a higher chance of incurring into an electrical defect.

At step 205, based on the results of the previous steps, the electrical defect statistics may be determined.

At step 206, a function may be chosen that maps electrical defects to possible neuromorphic faults. This function may depend on multiple factors, such as the statistics of MNB operating conditions (which may be based on e.g. MNB design, the statistics of MNB inputs, configurations and operating conditions) and the chosen taxonomy of neuromorphic faults 209. The function may be determined based on a compromise between a pre-determined accuracy and a pre-determined model complexity. For example, an approach could be to focus on the most common electrical defects for each MNB.

At step 207, and based on the mapping from the electrical defects to neuromorphic faults, the statistics of neuromorphic faults are also determined.

A formal mathematical framework for the extraction of the statistics on e.g. electrical defects at step 205 and/or neuromorphic faults at step 207 is here introduced.

Given the focus on every single MNB, it may be reasonable to assume that only one defect will occur in a certain MNB at a time. Let N denote the total number of electrical defects possible within the chosen defect modeling framework, namely in the considered defect universe and let E define the defect universe including all the electrical defects as E = {*e*₁, *e*₂,..., *e_{N}*} where each *eᵢ* represents the i-th electrical defect, and i is an index such that *i* ∈ {1,2,..., *N*}*,* so that each electrical defect *eᵢ* corresponds to a unique identifier *i*.

The probability of an electrical defect *eᵢ* to occur is defined as *P*(*eᵢ*). Consistently with the one-defect injection framework it is possible to assume that $P \left({e}_{i}∩{e}_{j}\right) = 0 ∀ i , j \left(i\neq j\right)$ (1)

At the same time, it is reasonable to assume that the most common scenario corresponds to the absence of defects, namely $P \left(∅\right) ≫ P \left({e}_{i}\right) ∀ i$ (2)

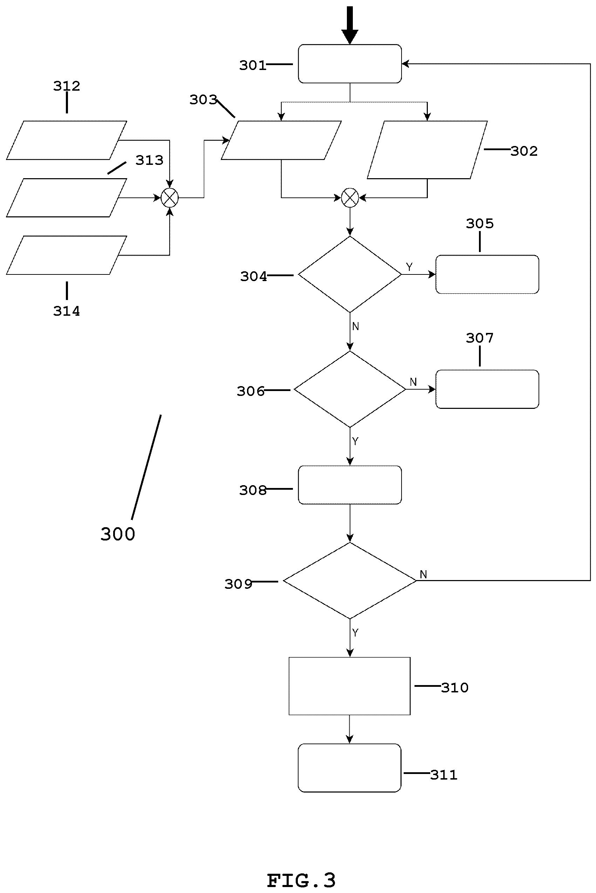

The reason why it is convenient to obtain statistical information also at the intermediate electrical level is because the simulation framework for the test set generation is defined at the electrical level. Having the electrical defect statistics helps us to refine the test set through a customized weighted coverage function, which will be thoroughly described in the embodiment relating to FIG. 3. The accuracy of the overall simulation-based statistics may be later refined based on experimental results.

Based on the probability distribution of inputs and operating conditions, electrical defects may result in neuromorphic faults, which can be either behavioral, i.e. causing a significant change in the behavior of the MNB, or parametric, i.e. causing a moderate change in one or few specs of the MNB.

By categorizing the variety of possible behavioral and parametric faults, it is possible to derive a neuromorphic fault taxonomy (step 103) for each MNB. As mentioned before, by means of high-level NN simulation with fault injection, a neuromorphic risk coefficient can be assigned to each defect class, accounting for the impact that this kind of defect has on the network performance.

The network sensitivity to faults may depend on where the fault is located, typically having higher impact on the final layers, on the network topology, on the training procedure, on the final application, and on many other factors. A neuromorphic risk coefficient can be estimated for each neuromorphic defect class relying on simplifying assumptions and focusing on the most common case.

For example, if the accelerator is reconfigurable, it is safe to assume that no faulty MNB will be chosen for the final or most delicate layers, thus the fault can be assumed to occur in an intermediate, standard layer.

As a further example, a relative neuromorphic risk coefficient may be used, which is a figure of merit more robust against variations of the NN topology and of the application. E.g., while topology A can be more fault-tolerant than topology B, it is likely that fault class X would be more detrimental (or more likely to be detrimental) than fault class Y in both topologies.

If the accelerator is meant for addressing multiple applications with comparable occurrence and importance, it may be convenient to extract an average impact of each fault class. Furthermore, if multiple NN topologies are taken into consideration, it may be convenient to focus on the standard layer type and extract an average impact.

Obtaining a clear picture of the neuromorphic defect taxonomy and of its neuromorphic risk coefficients has multiple advantages throughout the whole design and implementation chain of the accelerator, as well as network level in terms of improved NN design, calibration, and mapping routines. Furthermore, the coefficient may be an input of the weighted coverage function, enabling it to prioritize the most detrimental defects.

Given the actual testing capabilities and the observable physical quantities on the accelerator, a test set (step 105 and further) for defect detection must be performed for every manufactured product. The objective is to detect defects and possibly discard the accelerator based on the comparison between the test outcomes and the tolerance windows, i.e. the predefined acceptable range for the test outcomes. The test set may aim to optimize one or more of the following metrics: low escape rate, low overestimation during chip binning, low false alarm or false positive rate, low underestimation during chip binning and low testing time. These metrics are disclosed below.

The low escape rate metric may be the percentage of completely non-functional chips that reach the customer, i.e. chips that cannot deliver the minimal performance for the desired task. The expression 'completely non-functional' is here adopted because NN accelerators usually present a layered and granular architecture comprising multiple instances of different MNBs, resulting in different possible defective behaviors. As an example, a defective power supply unit will probably lead to a completely non-functional chip that must be discarded (e.g. in step 108), while a defective neuron may result either in a negligible impact or in a slight decrease of the accelerator performance. In order to address this complexity, a custom metric is introduced in the following, referred to as wrong chip binning. The low escape rate metric may be important, given its significant economic consequences.

The low overestimation during chip binning metric can be implemented because while completely non-functional chips are taken into account in the low escape rate metric, nonetheless an overestimation of the chip capabilities may lead to delivering a product that will have a lower-than-expected performance on the chosen application.

The low false alarm/false positive rate metric may be defined as the percentage of working chips that one discards. This metric accounts for the impact of tests in the overall manufacturing yield, since a high false positive rate means that a significant number of functional chips are discarded, representing an economic loss.

The low underestimation during chip binning metric may be defined because an underestimation of the chip capabilities directly lead to an unjustified decrease of the accelerator price and thus to an economic loss.

The low testing time metric may mean low testing cost. Testing time is usually a significant entry in the overall product cost, thus minimizing the testing time brings a significant economic advantage.

Some of the presented metrics may be conveyed into aiming for a high weighted defect coverage, which is described in the embodiment relating to FIG. 3.

FIG. 3 schematically shows a method 300 to compute weighted defect coverage during test set optimization via simulation according to the invention. The embodiment discloses the steps and calculations needed for computing the weighted defect coverage during the simulative campaign devoted to test set optimization. FIG. 3 is a flowchart depicting the computation of the weighted defect coverage during the simulative campaign devoted to test set optimization.

Regarding the choice of the tests composing the test set, several options and approaches are possible, such as testing every MNB individually, testing various MNB in parallel through a single test that involves multiple MNBs, adopting inference-like tests where each neuromorphic module or the overall neural processor is tested as in normal inference operations but with customized input aiming to defect detection. Of course, there is an ever-present trade-off between the parallelization of the tests, providing throughput improvement, and the accuracy of such tests, that would involve more and more MNBs and other circuits prone to noise, variability, and other nonidealities.

Traditionally, the final goal of the testing campaign is to detect as many electrical defects as possible. Given the practical impossibility of having complete defect coverage, i.e. detecting all the defects, there is the necessity for creating a metric that helps optimise the tests toward the detection of the most significant defects, such as the most likely or most detrimental ones. This metric is referred to as the weighted defect coverage function and it may depend on at least one of: electrical defect probability distribution, neuromorphic risk coefficient of the neuromorphic fault class corresponding to the considered electrical defect, basic analysis of the defect impact at electrical level and/or limitations of the defect simulation of which the user is aware.

At step 301, an electrical defect *eᵢ* is sampled. The goal, in steps 301-308 is to compute the defect weight *Wᵢ* at step 308 for the electrical defect *eᵢ*. At step 309, it is then determined whether all the selected electrical defects were evaluated. If not all the selected electrical defects were evaluated (N), a new electrical defect is sampled at step 301 from the set of the selected electrical defects and the steps 302-308 are repeated. The steps 30-308 will now we explained in detail.

At step 302, the electrical defect probability distribution *P*(*eᵢ*) (see the embodiment of FIG. 2) is retrieved for the electrical defect *eᵢ*. The electrical defect probability distribution is defined as how much it is probable that a certain electrical defect will occur. This depends on many factors, such as device sizing, circuit design choices, physical layout design, and process statistics.

At step 303, the neuromorphic risk coefficient *ρᵢ* of the neuromorphic fault class corresponding to the considered electrical defect *eᵢ* may be determined. The neuromorphic risk coefficient may be a way to either increase or decrease the single defect coverage. It is convenient to deploy a neuromorphic risk coefficient only for the electrical defects which are known to likely translate into a particular neuromorphic fault in the most common scenarios. This is because in some cases it might not be straightforward to model the relationship between an electrical defect and a neuromorphic fault, because inputs and operating conditions of the MNBs can vary, as well because the application and deployed NN influence the risk coefficient. The neuromorphic risk coefficient *ρᵢ* may be determined based on at least one of application type, network type, architecture, statistics of the MNB's operating conditions and /or the neuromorphic fault taxonomy.

At step 304, a basic analysis of the electrical defect's impact at electrical level is performed. This basic analysis may rule out defects that are clearly not detrimental or highlight defects that are clearly catastrophic for the function of the block or chip. For instance, it may happen that an electrical defect is not detrimental because of functional redundancy of the circuit design or because it is almost never stimulated, as in the case of a defect on an unused 'logic path' of a transmission gate. If the electrical defect *e*_*i* is clearly not detrimental (Y), at step 305 the weight *w_{circuit,i}* = *Wᵢ* of the electrical defect *eᵢ* is set to zero. If it is not determined that the electrical defect *eᵢ* is clearly not detrimental (N), the method 300 continues with step 306.

At step 306, it is determined whether the electrical defect *eᵢ* can be detected with simulations. Limitations of the defect simulation of which the user is aware may be implemented since the weighted coverage may be tailored accounting for defects that are detected or not detected because of simulation limitations. If it is determined that the defect cannot be detected with simulations (N), at step 307 again the weight *w_{circuit,i}* = *Wᵢ* of the electrical defect *eᵢ* is set to zero. If it is determined that the defect can be detected with simulations (Y), the method 300 continues with step 308.

At step 308, the defect weight *Wᵢ* of the electrical defect *eᵢ* is computed. One or more of the parameters determined in steps302-307 may be taken into account in this computation. The single defect weight *Wᵢ* may be computed as ${W}_{i} = P \left({e}_{i}\right) ⋅ {ρ}_{i} ⋅ {w}_{circuit , i}$ (3) where *ρᵢ* is the neuromorphic risk coefficient accounting for their impact at neuromorphic computing level and *w_{circuit,i}* is a circuit-related weighting factor customizable by the user, whose purpose is to rule out electrical defects that are harmless or virtually inactive electrical defects because of design choices or inherent circuital redundancy, as well as to rule out error due to simulation limitations and simulation artifacts.

At step 309, as mentioned it is then determined whether all the selected electrical defects were evaluated. If not all the selected electrical defects were evaluated (N), a new electrical defect is sampled at step 301 from the set of the selected electrical defects and the steps 302-308 are repeated. If all the selected electrical defects were evaluated (Y), the method 300 continues with step 310.

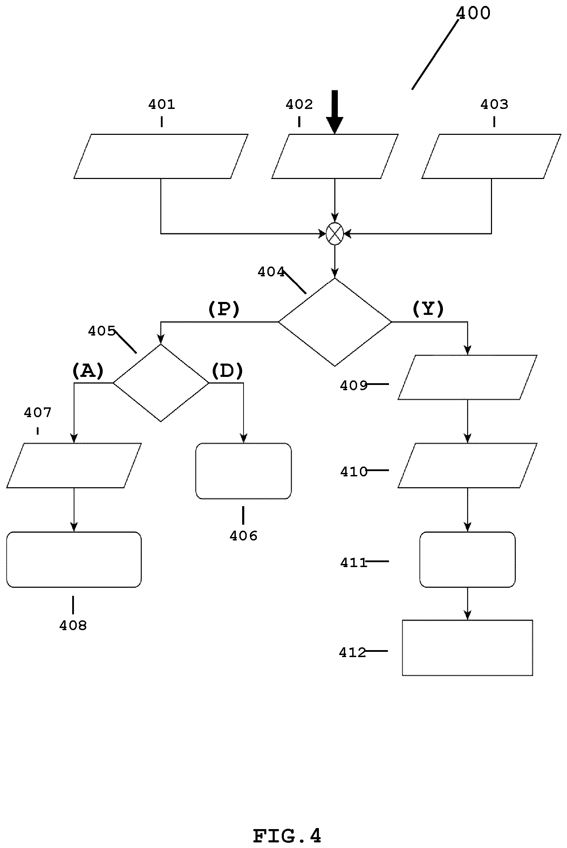

At step 310, selected defective circuits are simulated according to a chosen test set and chosen tolerance windows. A simulation of the test set is thus performed on the number of selected defective circuits, and a defect is determined to be detected by the chosen test set if the values of a particular test in the chosen test set lies outside one of the chosen tolerance windows. The simulation may be performed by a computing system comprising at least one processor and a memory storing instructions which, when executed by the processor, cause the system to: (1) receive or generate a representation of a plurality of defective circuits; (2) select a subset of defective circuits for simulation; (3) apply a chosen test set to each selected defective circuit; (4) compare the simulated output values for each test to corresponding tolerance windows; and (5) determine that a defect is detected if a test result falls outside its associated tolerance window. The application of the chosen test set to each selected defective circuit may comprise providing input values defined by the test set to a simulation model of the defective circuit, executing a simulation of the defective circuit in response to the input values, and obtaining output values corresponding to each test in the test set. The embodiment of FIG. 4 discloses approaches for the definition of a tolerance window and is discussed below.

At step 311, the weighted defect coverage *WC* is computed. The reason why one may focus on coverage for electrical defects is because the most powerful conceptual, mathematical, and simulation tools are available at circuital level, making it convenient to carry out simulations and estimate the coverage, as well as keeping the definition framework related to the coverage at electrical level. A general formula for the weighted defect coverage *WC* reads as follows $WC = \frac{\sum {W}_{i} \times {detected}_{i}}{\sum {W}_{i}}$ (4) where *Wᵢ* represents the weight of the defect *eᵢ* and *detectedᵢ* is a boolean variable tracking whether that defect has been detected or not.

FIG. 4 schematically shows a method 400 for obtaining a tolerance window definition according to the invention. The embodiment discloses the two main proposed approaches for the definition of the test tolerance windows, targeting either performance at MNB level or MNB yield. FIG. 4 shows a flowchart illustrating approaches for tolerance window definition.

The experimental results of the test set must be compared against previously defined acceptable ranges, referred to as tolerance windows. While defining those, it is important to include the factors influencing the measurement and the reliability of tolerance windows, such as: resolution of the testing setup, including the limitations of the instruments, board, package, pads, chip, etc.; parasitic effects and nonidealities of the circuit under test, such as noise, leakages, etc.; and/or impact of process variations and mismatches when considering the target metric, which is either the performance or the yield.

Therefore, parasitic effects and limitations of MNBs and peripheral circuitry at step 401, testing equipment capabilities at step 402, and process variations and mismatches at step 403 are taken into account. The process variations and mismatches may be especially important, since it considers the target metric, which is either the performance or the yield of the accelerator.

At step 404, it is determined whether to target performance or yield as the target metric. The target metric determines the approach for defining tolerance windows for the tests, and one can thus opt for two different approaches: a performance-targeting approach (P) or a yield-targeting approach (Y).

In the performance-targeting approach, the desired specifications and performance of the single MNB are considered as a fixed target, while MNB yield may come as a process result. The implementation of this approach may be more straightforward.

In the yield-targeting approach the MNB yield is considered a fixed target, while specifications and performance at MNB and higher-level blocks may come as a result. This approach may be made possible by the inherent robust and reconfigurable nature of most NN hardware accelerators. While such an approach presents few more complexities, it may represent a significant economic advantage.

The following subsections are devoted to a deeper analysis of the two approaches (Y and P) for tolerance window definition in method 400.

If at step 404 the performance-targeting approach (P) is chosen, this is the more straightforward approach. It may comprise choosing a window of acceptable outcomes per MNB per each test, by relying on the specifications one considers sufficient for the targeted performance metrics of the considered MNB and of the overall system.

At step 405 it is determined how the requirements of the tolerance windows are defined, either by design (D) or by application (A).

If the specification is done by design (D), at step 406 the specification of the tolerance window can thus be defined during MNB design by looking at the raw performance and metrics of the single MNB.

If the specification is done by application (A), at step 407 by high-level network and architecture simulations can be performed which dictate the average requirement at MNB level for a particular application. At step 408, a tolerance window definition can then be determined based on the application, architecture and network as simulated.

In both cases, the performance-targeting approach can be extended to accommodate for a scoring system, consisting of various tolerance windows instead of a single pass or fail window.

If at step 404 the yield-targeting approach (Y) for tolerance window definition is chosen, then steps 409-412 of method 400 may be followed as discussed below.

While the standard performance-based procedure would rather require to fix tolerance windows based on target specifications and performance, and only afterwards computing the yield, the proposed yield-targeting approach rather starts by defining a target yield based on which it is possible to extract the tolerance windows.

The core concept relies on the fact that the robust and reconfigurable nature common to the vast majority of NN accelerator makes it possible to trade the MNB average yield with a decreased performance of the MNBs themselves, since there is supposedly room for manoeuvre at algorithmic level for still obtaining acceptable performance at system level, by means of solutions such as remapping, calibration techniques, customized training and retraining, modification of the NN topology, deployment of a larger but still convenient number of MNBs, et cetera.

As an example, it is possible to set a yield corresponding to 95% of the manufactured MNBSs as the information dictating what will be accepted or not, resulting in a consequent definition of the specifications corresponding to the worst-case scenarios within the 95% of the manufactured MNBs. There are a few characteristics that allow and may suggest to adopt this approach.

First of all, from a business perspective, this approach allows to trade the yield with other product or service characteristics, leaving more degrees of freedom for intervening in the business model or in the supply chain. As an example, a lower MNB performance can be compensated by a more substantial support on the software or algorithmic part that would enable the adoption of customized topologies and techniques, therefore allowing to trade yield with support on the application.

Secondly, the adoption of a chip binning scheme (see step 118 of method 100, which is worked out further below), which gives some room for manoeuvre in the target yield depending on the application and use cases.

Thirdly, if the product under consideration is at an early stage of development, it can be the case that the specifications at block level are not exactly determined, especially in the field of neuromorphic computing where it is not straightforward to link the specifications of the building blocks to the final performance metrics of the system.

Of course, the aforementioned flexibility of the NN accelerator to reach the same system performance with lower performance at MNB level remains valid within a limited range of scenarios, whereas stretching beyond certain boundaries, e.g. in terms of effort at algorithmic level or numbers of required MNBs, would become first economically meaningless and later practically unfeasible. Therefore, the yield-targeting approach still needs statistical analysis to understand and map the relationship between yield and single block specifications, based on which it is possible to estimate meaningful and convenient tolerance windows.

At step 409, the targeted yield of the MNB is chosen. This may be a trade-off with algorithmic and/or development efforts of the accelerator.

At step 410 probabilistic simulations are performed to estimate the performance distribution of the MNB. In other words, using the probabilistic simulations, for all MNBs a performance is determined, and one can then generate a performance distribution of all MNBs.

At step 411 the tolerance windows defined by the targeted MNB yield are determined.

At step 412 the necessity and determination of potential retraining, calibration, remapping, network modification et cetera is performed.

It is interesting to point out that, when adopting this approach, not only the test set influences the final yield by having a certain false positive rate, but also the target yield influences the test set optimization via the tolerance windows definition, since these determine the weighted defect coverage.

As an example, consider the parameter neuronal spiking frequency. Using a performance-targeting approach, one would for example discard all neurons that are not spiking with a frequency between 1 and 2 MHz. Using a yield-targeting approach however, one targets a particular a yield and based on a probabilistic distribution, one is forced to accept neurons that are spiking with a frequency between 0.5 and 5 MHz. One can then perform retraining, calibration, remapping and/or network modification such that these accepted neurons operate in the accelerator at an adequate neuronal spiking frequency or that, more generally, the neural network or the accelerator is able to achieve the requested performance.

In order to maximize yield and usability, a chip binning scheme (see step 118 of method 100) is adopted, which consists in allocating the manufactured IC accelerators to a particular bin based on their tested performance to the appropriate application or customer requirement.

However, given the layered and granular architecture of most NN hardware accelerators, the performance evaluation based on defect analysis may embody more detailed metrics at the MNB level rather than simply discarding faulty chips. In order to do so, a neuromorphic scoring system (again see step 118 of method 100) is devised, whose computation is carried out as discussed below.

In a first step, for each MNB, tests assess the performance gap between the MNB under test and a nominal MNB, according to specific metrics tailored around the desired functionality and performance of the various MNB types. The nominal MNB is also denoted the ideal MNB, e.g. the MNB without defects or faults that behaves per design. The nominal MNB can for example be defined by software. Depending on the performance gap, a individual score ranging from 0 to a pre-defined maximum value is assigned to each MNB, with 0 representing a completely non-functional block and the maximum value a block that is virtually ideal.

In a second step, the global score is computed of the accelerator (comprising a number of MNBs) as a function at least one of all the MNB scores, of the availability and performance of every MNB type, and/or of possible spatial constraints given by limited availability of MNBs in particular locations. The latter is inserted to account for possible constraints given by the network topology, e.g. a minimum number of high-performance neurons per layer.

A mathematical framework that may be used for the computation of the neuromorphic scoring system is here introduced.

Let *m* be the different MNB types comprised in a generic NN hardware accelerator, wherein the different MNB types are referred to as *x*₁, *x*₂,*..., xₘ* and let *N_{xᵢ}* denote the total number of units of the MNB type *xᵢ* present in the considered NN hardware accelerator. Let *s_{xᵢ}*(*j*) be the individual score for the unit *j* of the MNB type *xᵢ*, ranging from 0 to a predefined maximum value depending on the performance gap with the ideal functionality and performance of the considered MNB type. The score *S_{xᵢ}* for a particular MNB type *xᵢ* is then computed as follows: ${S}_{{x}_{i}} = {\sum }_{j = 1}^{{N}_{{x}_{i}}} {s}_{{x}_{i}} \left(j\right)$ (5)

The sum of the MNB individual scores is then defined as ${S}_{global} = {α}_{{x}_{1}} {S}_{{x}_{1}} + {α}_{{x}_{2}} {S}_{{x}_{2}} + … + {α}_{{x}_{m}} {S}_{{x}_{m}} = {\sum }_{i = 1}^{m} {α}_{{x}_{1}} {S}_{{x}_{1}}$ (6) where *α_{xᵢ}* is the impact coefficient related to the MNB type *xᵢ. S_{global}* is thus a metric that sums all scores of the particular MNB types weighted by their impact or importance. At the same time, it is fundamental to assess and account for the availability of units from each MNB type, given their unique importance in the processing chain. To this aim, the neurofunctional score *S_{neurofunctional}* is defined as ${S}_{neurofunctional} = {\sum }_{i = 1}^{m} {β}_{{x}_{i}} f \left({S}_{{x}_{i}}, {θ}_{{x}_{i}}\right)$ (7) where *β_{xᵢ}* is a second impact coefficient corresponding to the MNB type *xᵢ* and *θ_{xᵢ}* is the related threshold parameter. The threshold parameter parametrizes when the availability of well-performing MNB units drops too low so that an abrupt behavioral change in the accelerator occurs. Both are introduced to account for possible different needs concerning the availability of MNB units, considering also a minimum number of required units. Of course, such factors depend on the network topology, the training procedure, and the application. Note that *S_{neurofunctional}* is a metric for the weighted sum of the function that each MNB embodies.

It is important to notice that, as mentioned before (see e.g. step 117 of method 100, step 412 of method 400, which can be the same step (e.g. in case of yield-targeting approach) or different steps (e.g. in case of performance-targeting approach)), depending on the practical implementation of the accelerator, a certain degree of reconfigurability of the NN across the various levels of the neuromorphic architecture can make some neuromorphic fault classes not detrimental, unless they represent a huge portion of the total number. Even in the case of such an error occurring in a sensitive layer, such as the last one, a reconfigurable NN would likely make it possible to map the hardware so that the most important layers are assigned to the best performing MNBs.

In presence of a certain degree of reconfigurability, the chip binning scheme can be thus extended to accommodate for this feature. However, this approach can be adopted e.g. if it is expected to perform an inference check on the accelerator and the consequent possible custom remapping on every accelerator, which might not be economically meaningful.

The final factor influencing the general neuromorphic score of the accelerator accounts for spatial resources and constraints. It is possible to define a complex function *S_{local}* as ${S}_{local} = f \left({N}_{modules}, {{p}_{{x}_{i}}}^{{module}_{i}}, {{t}_{{x}_{i}}}^{{module}_{i}}, reconfigurability\right)$ (8) which is influenced by the accelerator architecture, the requirements of each module, as well as by the degree of reconfigurability of the system. *S_{local}* may form a metric that takes into account e.g. local structures, e.g. if one layer comprises a large number of faulty MNBs, each individual faulty MNB might not be detrimental, but because it is concentrated at a local structure it may render the entire layer faulty. In particular, *N_{modules}* represents the number of modules/local structures through which the neuromorphic architecture is organized, *p_{xᵢ}^{moduleᵢ}* is the number of units of MNB type *xᵢ* present in the module i that are rated as acceptably performing, and *t_{xᵢ}*^{moduleᵢi} is the minimum number of units of MNB type *xᵢ* in the module i that must be acceptably performing in order for the module to be active and functioning. It is important to point out that the label 'module' can refer to different levels of the architecture hierarchy, here summarized as 'module' for the sake of brevity.

The neuromorphic score of a considered accelerator may then be computed as the sum of the three metrics. $S = {S}_{global} + {S}_{neurofunctional} + {S}_{local}$ (9)

One can also define the neuromorphic score as a sum of a subset of the metrics *S_{global}, S_{neurofunctional}* and *S_{local}.* The resulting score S is then matched against the chosen chip bins, namely the performance boundaries chosen for ensuring that a neural processor delivers the expected performance for a particular application. Noticably, the chip bin definition is a function of the applications and of the provided development support in terms of calibration, remapping, and retraining of the NN.

An example of a possible adoption of the proposed neuromorphic scoring system for a chip binning scheme is discussed below.

A hardware mixed-signal NN accelerator based on three MNB types is taken as an example, the three MNB types being the neuron, synapse, and presynapse, and let *Nₙ, Nₛ,* and *Nₚ* denote the total number of neurons, synapse, and presynapse of the hardware mixed-signal NN accelerator, respectively.

Along the same line, define *sₙ, sₛ,* and *sₚ* as the individual score for each unit of the three considered MNB types, ranging from 0 to 3 depending on the performance gap with the ideal functionality and performance of the corresponding MNB type.

The scores *Sₙ, Sₛ,* and *Sₚ* for each MNB type are then computed as follows ${S}_{n} = {\sum }_{j = 1}^{{N}_{n}} {s}_{n} \left(j\right)$ (10) ${S}_{s} = {\sum }_{j = 1}^{{N}_{s}} {s}_{s} \left(j\right)$ (11) ${S}_{p} = {\sum }_{j = 1}^{{N}_{p}} {s}_{p} \left(j\right)$ (12)

While the sum of the MNB individual scores is computed as ${S}_{global} = {α}_{n} {S}_{n} + {α}_{s} {S}_{s} + {α}_{p} {S}_{p}$ (13) where *αₙ*, *αₛ,* and *αₚ* are impact coefficients corresponding to the neuron, synapse, and presynapse, respectively. Given the adopted architecture of the accelerator, the neurofunctional score *S_{neurofunctional}* for example uses as function *f*(*S_{xᵢ}, θ_{xᵢ}*) a sigmoidal function *σ*(*S_{xᵢ}, θ_{xᵢ}*) that well describes the abrupt behavioral change occurring when the availability of well-performing MNB units gets close to the threshold parameter *θ_{xᵢ}*.The sigmoid function *σ* is defined as $σ \left(x\right) = \frac{1}{1 + {e}^{- x}}$ (14) and the neurofunctional score *S_{neurofunctional}* is computed as ${S}_{neurofunctional} = {β}_{n} σ \left(\frac{{S}_{n}}{3 {N}_{n}}-{θ}_{n}\right) + {β}_{s} σ \left(\frac{{S}_{s}}{3 {N}_{s}}-{θ}_{s}\right) + {β}_{p} σ \left(\frac{{S}_{p}}{3 {N}_{p}}-{θ}_{p}\right)$ (15) where *βₙ*, *βₛ,* and *βₚ* are additional impact coefficients corresponding to the three MNB types. The input argument of the sigmoid function consists of the average individual score of each MNB type, normalized on the maximum achievable score 3, shifted by the tunable threshold parameters *θ*. The three dedicated sigmoidal thresholds *θₙ*, *θₛ,* and *θₚ* account for possible different networks' needs concerning the availability of the MNB types. Finally, the function *S_{local}* is for example structured as follows ${S}_{local} = γ ⋅ \left[\begin{matrix}- \frac{{N}_{modules}}{2} \\ + {\sum }_{i = 1}^{{N}_{modules}} sign \left({{p}_{n}}^{{module}_{i}}-{{t}_{n}}^{{module}_{i}}\right) sign \left(\begin{matrix}{{p}_{s}}^{{module}_{i}} \\ - {{t}_{s}}^{{module}_{i}}\end{matrix}\right) sign \left({{p}_{p}}^{{module}_{i}}-{{t}_{p}}^{{module}_{i}}\right)\end{matrix}\right]$ (16) where *γ* is the scaling parameter for the local score *S_{local}*, while *pₙ*, *pₛ*, and *pₚ* refer to the number of acceptably performing neurons, synapses, and presynapses in the considered module, respectively. Similarly, *tₙ, tₛ,* and *tₚ* refer to the minimum number of acceptably performing neurons, synapses, and presynapses, in the considered module, respectively. The purpose of the adopted formulation is to rule out any module that cannot guarantee the minimum number of performing MNBs and, in case the number of active and performing modules is less than half of the available modules, to lower the overall score thanks to the negative offset - $\frac{{N}_{modules}}{2}$. The neuromorphic score of the considered accelerator is computed as the sum of the three entries $S = {S}_{global} + {S}_{neurofunctional} + {S}_{local}$ (17)

As aforementioned, the resulting score S is then compared with the pre-defined chip bins to allocate each manufactured accelerator to the appropriate application.

The first methodology for defect analysis and detection in mixed-signal IC accelerators of Neural Networks (relating to the embodiment of FIG. 1) may comprise the following steps.

Firstly, a neuromorphic scoring system for performance estimation and efficient allocation of computing resources, based on an ad hoc developed mathematical framework accounting for different aspects influencing the final performance of a mixed-signal NN accelerator, such as both the global and local abundance of well-performing MNBs, as well as the relative availability of different neuromorphic computing primitives.

Secondly, a chip binning scheme based on the adopted neuromorphic scoring system and on the targeted final applications.

Thirdly, versatility and flexibility in yield targeting and tolerance window definition via the yield-targeting approach, where yield can be traded off with other resources such as calibration, remapping, and retraining efforts. This approach leverages the robust and reconfigurable nature of the NN processor, which makes it possible to trade the MNB yield with a decreased performance of the MNBs themselves, because there is room of manoeuvre at algorithmic level for still obtaining satisfactory performance at system level. Among the characteristics that allow and may hint to this approach there are the higher flexibility in the business model, the adoption of a chip binning scheme, and a possible early-stage of development of the considered product.

Fourthly, separate and custom procedure for the neuromorphic computing circuitry compared to the rest of the circuitry.

A method for the optimization of the test set for defect detection in mixed-signal IC accelerators of Neural Networks may comprising the following steps.

Firstly, customized weighted coverage function for defect detection with the corresponding mathematical framework, having as influencing factors the electrical defect statistics, neuromorphic risk coefficient for each neuromorphic fault class, basic analysis of the undetectable or catastrophic defect impact at electrical level, limitations of the simulation environment.

Secondly, extraction of defect and fault statistics, aiming to improve the weighted coverage of the test set by means of devoting resources on the most important defects.

Thirdly, neuromorphic fault taxonomy for every MNB type with corresponding neuromorphic risk coefficients assigned to each neuromorphic fault class, aiming to improve the weighted coverage of the test set by means of devoting resources on the most significant and detrimental defects.

Fourthly, customized figure of merits for the test set optimization, considering the escape rate, overestimation and underestimation during chip binning, false positive rate, and the testing time and costs.

A method for extraction of defect and fault statistics, in addition to improving the weighted coverage of the test set by means of devoting resources on the most important defects, can significantly improve the network calibration or remapping schemes.

A methodology for defect analysis and detection in mixed-signal IC accelerators of Neural Networks compliant with the industry-leading IEEE P2427 standard draft. The compliance is embodied in, but not limited to, the following points: defect injection scheme based on injecting one electrical defect at a time; defect statistics based on schematic and physical layout design; clear and consistent definition of the weighted coverage function; compatible definitions and models of electrical analog defects; agnostic to the sampling method adopted to sample defects.

A description of a feasible approach and reasonable assumptions for the generation of the neuromorphic fault taxonomies for each MNB, based on network sensitivity, remapping capabilities, and applications.

A description on the factors influencing the function mapping electrical defects to possible neuromorphic faults, such as the MNB design, the statistics of MNB inputs, configurations, and operating conditions, the chosen taxonomy of neuromorphic faults, with subsequent proposal of an adoptable feasible approach based on only the most common scenarios for each MNB, because of the need to find a compromise between accuracy and model complexity.

A refinement of the procedure by information gathering throughout the steps of the methodology, such as defect statistics, fault statistics, effective yield, variability, observability issues, et cetera.

A refinement of the circuit design by information gathering throughout the steps of the methodology, such as defect statistics, fault statistics, effective yield, variability, observability issues, et cetera.

A refinement of the NN training procedure and NN topology by information gathering throughout the steps of the methodology, such as defect statistics, fault statistics, effective yield, variability, observability issues, et cetera.

The described invention provides an innovative solution for making defect analysis and detection both feasible and efficient in products that are required to meet high reliability and safety standards. This is especially important in industries such as aerospace, automotive, medical devices, and telecommunications, where failure to adhere to these standards can lead to significant safety risks, costly repairs, or operational disruptions. By incorporating the proposed method, manufacturers can ensure that their mixed-signal IC accelerators of NN models undergo rigorous testing to identify defects at an early stage of production, thus reducing the likelihood of defects reaching the final product and ensuring the safety and reliability of the end-user application.

Furthermore, the invention offers a practical approach for decreasing the overall testing costs, making it economically viable even for products or accelerators used in non-critical applications, where testing costs could otherwise make the product non-profitable. These accelerators, which are usually adopted in fields such as data processing, artificial intelligence, and edge computing, benefit from lower-cost, efficient testing methods without compromising the quality or performance of the final product. The benefits of improving both the defect detection capability and cost-efficiency is a major advancement, as it allows manufacturers to maintain high standards of quality without incurring excessive testing costs.

Two or more of the above embodiments may be combined in any appropriate manner.

## Claims

1. A method for generating a test set for defect detection in a mixed-signal IC neural network accelerator, the accelerator comprising analog and digital components, the method comprising:
identifying a number of mixed-signal neuromorphic blocks present on the accelerator;
simulating the response of the accelerator to generated input signals, by modelling the analog and digital components and simulating the interaction between the analog and digital components in response to the input signals;
extracting from the simulation for each mixed-signal neuromorphic block a defect and/or fault statistics, wherein the defect and/or fault statistics is an estimation of how much the defect and/or fault is probable, wherein the defect is an electrical defect and wherein the fault is a neuromorphic fault;
creating a taxonomy of neuromorphic faults based on the extracted defect and/or fault statistics;
generating the test set for the accelerator based on the created taxonomy of neuromorphic faults.

2. The method of claim 1, wherein the defect and/or fault statistics is extracted by:
obtaining statistical information on a manufacturing process defect, preferably wherein the statistical information on the manufacturing process defect is a defect density or a defect size probability distribution, more preferably wherein the statistical information on the manufacturing process is obtained from an empirical model and/or experimental validation tests;
determining a physical design and/or layout of the mixed-signal neuromorphic blocks and/or of the accelerator;
mapping the manufacturing process defect to an electrical defect;
determining a transistor-level design of the mixed-signal neuromorphic blocks so as to determine which transistor-level design choices result in different physical defects collapsing onto the same electrical defect, or which transistor-level design choices result in different physical defects having a functional redundancy;
determining the defect statistics based on the statistical information on a manufacturing process defect, the physical design and/or layout, the mapping to the electrical defect and the transistor-level design of the mixed-signal neuromorphic blocks;
and preferably:
mapping the electrical defect to a neuromorphic fault, preferably wherein the mapping depends on the statistics of mixed-signal neuromorphic block operating conditions and/or the taxonomy of neuromorphic faults;
determining the fault statistics based on the defect statistics and the mapping.

3. The method of claim 1 or 2, wherein the generated test set is generated based on a weighted defect coverage, wherein the weighted defect coverage is determined by:
obtaining a neuromorphic risk coefficient for each defect, preferably wherein the neuromorphic risk coefficient is based on least one of application type, network type, architecture, statistics of the mixed-signal neuromorphic block's operating conditions and /or the neuromorphic fault taxonomy;
obtaining the defect statistics for each defect, preferably wherein the defect statistics is a defect probability distribution;
computing the defect weight for each defect on the basis of the product of the neuromorphic risk coefficient and the defect statistics;
simulating the execution of the test set on a set of simulated defective circuits of the accelerator, each defective circuit having a defect and obtaining a detection parameter that determines whether the defect is detected;
determining the weighted defect coverage as a quotient between the sum of each defect weight times the detection parameter and the sum of each defect weight.

4. The method of claim 3, wherein the neuromorphic risk coefficient of a neuromorphic fault is computed as an average impact of the neuromorphic fault on an inference of the neural network, preferably wherein the neuromorphic risk coefficient is determined based on a simulation of the neural network using fault injection.

5. The method of claim 3 or 4, wherein the defect weight for each defect is computed on the basis of the product of the neuromorphic risk coefficient, the defect statistics and a circuit-related weighting factor, wherein the circuit-related weighting factor is configured to rule out defects that are harmless and/or inactive, and/or to rule out simulation limitations and/or artifacts;
preferably wherein the circuit-related weighting factor for a particular defect is set to zero when it is determined that the particular defect is harmless and/or inactive, and/or when it is determined that the particular defect cannot be detected due to simulation limitations and/or artifacts.

6. The method of any one of the preceding claims, wherein the test set comprises tolerance windows, wherein the tolerance windows can be used to determine whether the experimental results of the test set are acceptable, wherein the tolerance windows are obtained either on the basis of performance or of yield;
wherein the tolerance windows are obtained on the basis of performance by:
if the specification is done by design, the specification of the tolerance window is defined during mixed-signal neuromorphic block design by looking at the raw performance and metrics of the single mixed-signal neuromorphic block; or
if the specification is done by application, simulating a high-level network and architecture so as to determine an average requirement at mixed-signal neuromorphic block level for a particular application and determining a tolerance window definition based on the application, architecture and network as simulated;
and
wherein the tolerance windows are obtained on the basis of yield by:
choosing a targeted yield of the mixed-signal neuromorphic block;
simulating the mixed-signal neuromorphic block to estimate a performance distribution of the mixed-signal neuromorphic block;
defining the tolerance window based on the targeted mixed-signal neuromorphic block yield and the estimated performance distribution;
determining required retraining, calibration, remapping, and/or network modification to obtain the targeted yield.

7. A method for testing and allocating a mixed-signal IC neural network accelerator of a neural network, the method comprising:
obtaining a test set for defect detection in the accelerator from the method according to any one of the preceding claims;
executing the obtained test set;
grading, based on the results of the executed test set, the accelerator using a neuromorphic scoring system to obtain an accelerator score;
allocating the accelerator to a particular chip bin or a particular application using the obtained accelerator score.

8. The method of claim 7, the method further comprising:
testing a power supply circuitry, input/output circuitry and/or non-neuromorphic circuitry present in the accelerator and on the basis of this test, determining whether the accelerator is usable;
wherein the obtained test set is executed if the accelerator is determined to be usable.

9. The method of claim 7 or 8, further comprising before the obtained test set is executed:
testing one or more mixed-signal neuromorphic blocks for defects that make the mixed-signal neuromorphic blocks not calibratable using a pre-defined calibration routine, and on the basis of this test, determining whether the accelerator is calibratable;
wherein the obtained test set is executed if the accelerator is determined to be calibratable.

10. The method of any one of the claims 7-9, wherein the neuromorphic scoring system comprises:
assessing, for each mixed-signal neuromorphic block, a performance gap between the mixed-signal neuromorphic block under test and a nominal mixed-signal neuromorphic block;
assigning, to each mixed-signal neuromorphic block, an individual score ranging from a value that represents a non-functional mixed-signal neuromorphic block to a value that represents an ideal mixed-signal neuromorphic block;
computing the neuromorphic score of the accelerator as a function of at least one of all the individual scores of the mixed-signal neuromorphic blocks present in the accelerator, of availability and performance of every mixed-signal neuromorphic block type, and/or of possible spatial constraints given by limited availability of mixed-signal neuromorphic blocks in particular locations.

11. The method of claim 10, wherein the neuromorphic score of the accelerator is based on at least one of: a metric that sums all individual scores of the particular mixed-signal neuromorphic block types weighted by their impact or importance, a metric that takes into account the availability of each mixed-signal neuromorphic block types, and/or a metric that takes into account the distribution of faulty mixed-signal neuromorphic blocks over local structures.

12. The method any one of the claims 7-11, wherein after the test set is executed, customized remapping and/or calibration can be performed based on the electrical defects present on the accelerator; and/or
wherein after the test set is executed, adaptation and/or retraining of the neural network topology is performed, based on hardware constraints imposed by the presence of electrical defects.

13. The method of any one of the claims 7-12, wherein the method further comprises:
collecting data from the execution of the test set;
using the collected data to refine the extracted defect and/or fault statistics.

14. The method of any one of the claims 7-13, wherein the method further comprises:
collecting data from the execution of the test set;
using the collected data to change the neural network design and training, and to change the accelerator architecture and circuit design.

15. A mixed-signal IC neural network accelerator of a neural network, allocated to a particular chip bin or a particular application using the method of any one of the claims 7-14.
